# EUROPÄISCHE PATENTSCHRIFT

(11) **EP 0 572 691 B1**
(45) Veröffentlichungstag und Bekanntmachung des Hinweises auf die Patenterteilung: **04.02.1998**
(21) Anmeldenummer: 92109250.8
(22) Anmeldetag: 02.06.1992
(51) Int. Cl.: H03F 3/60, H01P 1/15

(54) **Semiredundante Leistungsverstärker für Ein- und Mehrkanalbetrieb**
Semi-redundant type power amplifier for operation in one or more channels
Amplificateur de puissance semi-redondant pour fonctionnement dans un ou plusieurs canaux

(43) Veröffentlichungstag der Anmeldung: 08.12.1993
(73) Patentinhaber: MIKOM GmbH, 86675 Buchdorf (DE)
(72) Erfinder: Schmidt, Karl-Heinz. MIKOM GMBH, W-8851 Buchdorf (DE)
(74) Vertreter: Rapp, Bertram, Dr.

(56) Entgegenhaltungen:
- FR-A- 2 269 821
- FR-A- 2 284 226
- US-A- 4 626 806
- JOURNAL OF PHYSICS E. SCIENTIFIC INSTRUMENTS Bd. 19, Nr. 8, August 1986, BRISTOL GB Seiten 577 - 587 K.B. KLAASSEN ET AL 'INSTRUMENT SCIENCE AND TECHNOLOGY RELIABILITY IN INSTRUMENTATION'
- PATENT ABSTRACTS OF JAPAN vol. 9, no. 27 (E-294)(1750) 6. Februar 1985 &JP-A-59 172 816

## Beschreibung

Die Erfindung betrifft Leistungsverstärker für den Einsatz in Funknetzen in Ein- oder Mehrkanalbetrieb, welche aus Gründen der Flexibilität und Wirtschaftlichkeit auf den Einsatz von Kanalfilterweichen oder Hybridsummierern verzichten.

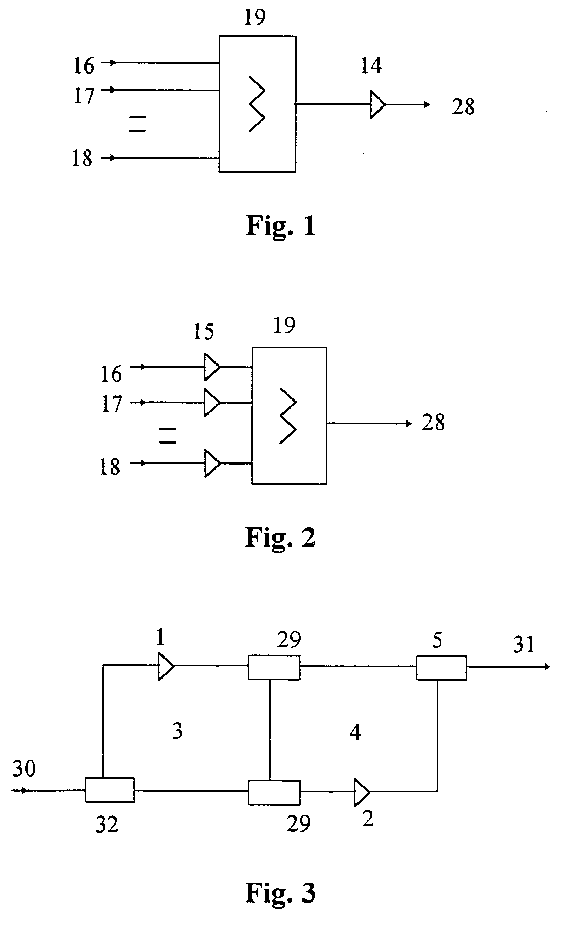

Sendestationen für Zellen mit begrenzter Anzahl von Teilnehmern (z.B. in ländlichen Gebieten, Tälern) oder Zellen mit kleiner, räumlicher Ausdehnung (z.B. Tunnel, Straßenzüge) senden meist nur wenige Träger mit kleiner Leistung ab. Der Einsatz eines hochlinearen Verstärkers 14 nach Fig. 1, welcher in Mehrkanalbetrieb alle abgesendeten Träger unter Berücksichtigung der Emissionsbestimmungen verarbeiten kann, bietet sich hier an. Bislang wurde aus Gründen der Betriebszuverlässigkeit auf den Einsatz von Mehrkanalverstärkern weitgehend verzichtet. Im Gegensatz zu herkömmlichen Systemen werden beim Einsatz von Mehrkanalverstärkern 14 mehrere Sendefrequenzen durch eine Komponente aufbereitet.

Die in Figur 1 gezeigte Verstärkeranlage besitzt beispielsweise einen den Kanälen 16 bis 18 zugeordneten Summierer 19. Dessen Signale werden von einem Mehrkanalverstärker 14 aufbereitet und an eine Sendeantenne 28 weitergegeben.

Herkömmliche Systeme verwenden einen Verstärker pro Sendefrequenz und fassen die Kanäle mittels Kanalweichen oder Summierern zusammen. Die in Fig.2 dargestellte Anlage besitzt pro Kanal 16 bis 18 einen Verstärker 15. Die Zusammenfassung erfolgt mittels eines Summierers 19, der seine Ausgangssignale an eine Sendeantenne 28 weitergibt.

Der Ausfall eines Verstärkers 15 führt in herkömmlichen Systemen nicht zu einer Betriebsunterbrechung - lediglich ein Kanal fällt aus. Bei Systemen mit Mehrkanalverstärkern 14 fallen alle Kanäle aus.

Um die Emissionsbestimmungen im Mehrkanalbetrieb einzuhalten, ist es notwendig, Verstärker mit Kompensationsschleifen nach Fig. 3, sogenannte Feedforwardverstärker, einzusetzen.

In Feedforwardverstärkern werden zwei Verstärkermodule 1, 2 in zwei Kompensationsschleifen 3, 4 verschaltet. Schleife 3 isoliert die im Hauptverstärker 1 erzeugten Störprodukte. In Schleife 4 werden diese Störprodukte vom Ausgangssignal subtrahiert. Dies geschieht im Ausgangskoppler/Summierer 5.

Bei Ausfall eines Verstärkermoduls tritt eine starke Beeinträchtigung der dynamischen Parameter auf; dies führt zu einer Reduktion der abgestrahlten Leistung und somit zu einer Beeinträchtigung der Funkversorgung.

In FR 2269821 wird die paarweise Anordnung von Verstärkern vorgeschlagen, um im Schadensfall die Funktion des schadhaften Verstärkers dem jeweils anderen mit zu übertragen. Auch Klaasen und van Peppen, ,,Instrument Science and Technology", S. 577 - 587 schlagen eine entsprechende Nutzung der redundante Bauweise von Geradeausverstärkern vor. Dies würde bei einem Feedforward-Verstärker jedoch eine Reihe zusatzlicher Bauteile erforderlich machen.

Ziel der Erfindung ist deshalb eine Verbesserung der Notlaufeigenschaften von Feedforward-Verstärkeranlagen bei geringem Konstruktionsaufwand.

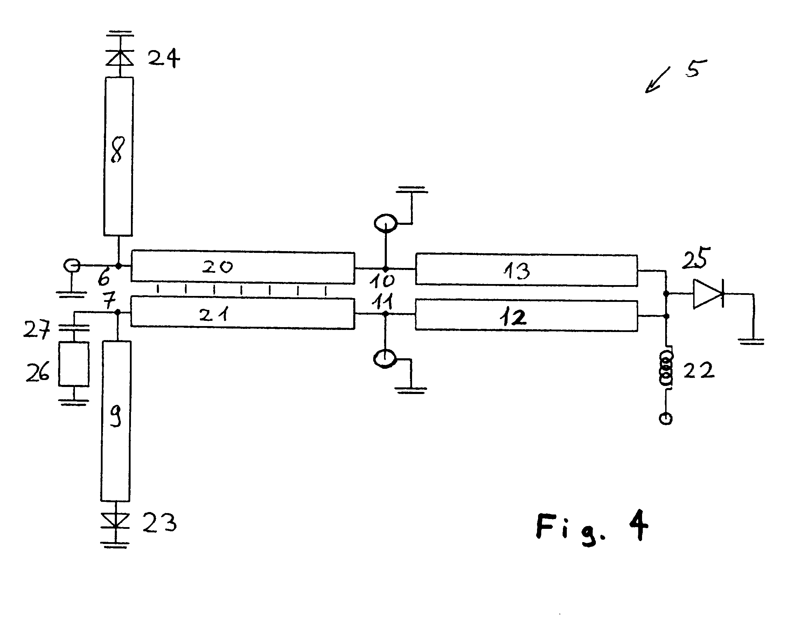

Gelöst wird die Aufgabe durch die Merkmale des Anspruches 1. Eine vorteilhafte Ausgestaltung ist Anspruch 2 entnehmbar. Ein Ausführungsbeispiel wird nachfolgend anhand der Fig. 3 und 4 erläutert.

Die Verstärkeranordnung nach Figur 3 besitzt einen Eingang 30 und einen Eingangskoppler 32, an den sich eine Schleife 3 mit einem Hauptverstärker 1 anschließt. Die Schleife 3 ist über zwei Schleifenkoppler 29 mit einer Schleife 4 verbunden. Die Schleife 4 enthält einen Fehlerverstärker 2. Die Schleife 4 ist über einen Ausgangssummierer 5 mit dem Ausgang 31 verbunden.

Durch Umschalten des Ausgangssummierers 5 wird das Summierverhältnis zugunsten noch intakter Schaltungsteile geändert. Beim Feedforwardverstärker übernimmt beim Ausfall des Hauptverstärkers 1 der Fehlerverstärker 2 die Signalaufbereitung als Geradeausverstärker.

Als schaltbarer Ausgangssummierer 5 wird ein in Fig. 4 dargestellter kurzgeschlossener Richtkoppler 20,21 verwendet. Durch Unterbrechen des Steuerstromes an den Pin Dioden 23 bis 25 wird an Port 6 und 7 ein Kurzschluß über die 1/4-Leitungen 8 und 9 transformiert. Gleichzeitig werden Port 10 und 11 über zwei 1/4-Leitungen 12 und 13 kurzgeschlossen. Die Koppeldämpfung zwischen Fehlerverstärker 2 (an Port 11 angeschlossen) und Systemausgang (Port 10) ist damit nahezu 0, während der Hauptverstärker 1 um ca. 20 dB vom Ausgang isoliert ist.

Die Kapazität 27 dient der DC-Entkopplung. Der ihr nachgeschaltete Widerstand 26 besitzt eine Terminierung von 50 Ohm. Spule 22 übernimmt die Einkopplung der Steuerspannung.

Die Steuerung der Ausgangssummierer 5 kann wahlweise durch eingebaute Überwachungssysteme oder ferngesteuert erfolgen.

Durch Isolierung von fehlerhaften Schaltungsteilen bei gleichzeitiger Änderung der Summierverhältnisse zugunsten intakter Module kann auch im Fehlerfall ein Notbetrieb mit gleichbleibenden Ausgangsdaten für Sendeträger aufrechterhalten werden. Lediglich die abgegebenen Störprodukte können unter Umständen die maximalen Werte der Emissionsbestimmungen überschreiten. Dies ist jedoch für einen begrenzten Zeitraum zulässig.

## Patentansprüche

1. Verstärkerschaltung mit mindestens einem Summierer (5) und mindestens zwei Verstärkern (1,2), die zusammen eine Feedforward-Konfiguration bilden, **dadurch gekennzeichnet**, daß der Summierer (5) im Normalbetrieb die Ausgangssignale der Verstärker (1,2) gemäß einem vorgegebenen Summierverhältnisses addiert, und daß, bei Ausfall eines Verstärkers (1,2) , dieser isoliert wird und der Summierer das Summierverhältnis der Ausgangssignale zugunsten intakter Schaltungsteile ändert.

2. Schaltung nach Anspruch 1, **dadurch gekennzeichnet**, daß zur Umschaltung ein Streifenleiterkoppler (20,21) dient.

## Claims

1. An amplifier circuit of at least one summer (5) and at least two amplifiers (1,2) which together form a feedforward configuration, **characterized in that**
in normal operation the summer (5) adds the output signals from the amplifiers (1,2) in accordance with a predetermined summer ratio and that in the event of failure of one amplifier (1,2) it becomes isolated and the summer alters the summer ratio of the output signals in favour of intact parts of the circuit.

2. A circuit as in Claim 1, **characterized in that**
for switching over a strip-line coupler (20,21) is used.

## Revendications

1. Montage amplificateur avec au moins un élément additif (5) et au moins deux amplificateurs (1, 2), qui forment conjointement une configuration à précompensation, **caractérisé** en ce que l'élément additif (5), en fonctionnement normal, additionne les signaux de sortie des amplificateurs (1, 2) selon un facteur d'addition prédéfini, et en ce qu'en cas de panne d'un amplificateur (1, 2), ce dernier est isolé, et l'élément additif modifie le facteur d'addition des signaux de sortie au profit des éléments intacts du montage.

2. Montage selon la revendication 1, **caractérisé** en ce qu'on se sert, pour la commutation, d'un coupleur à rubans conducteurs (20, 21).
